# EUROPÄISCHE PATENTANMELDUNG

(11) **EP 4 160 244 A1**
(43) Veröffentlichungstag der Anmeldung: **05.04.2023**
(21) Anmeldenummer: 21199876.0
(22) Anmeldetag: 29.09.2021
(51) Int. Cl.: G01R 33/56, G01R 33/561, G01R 33/54, G01R 33/563, G06N 3/02, G01R 33/565

(54) **PARTIAL-FOURIER-MAGNETRESONANZBILDGEBUNGSVERFAHREN MIT NEURONALEN NETZEN**

(71) Anmelder: Siemens Healthcare GmbH, 91052 Erlangen (DE)
(72) Erfinder: Zeller, Mario, 91054 Erlangen (DE)

(57) **Zusammenfassung**

Ein erfindungsgemäßes computerimplementiertes Verfahren zum Erstellen von Ausgleichsdaten, welche in einem mittels einer partiellen Fourier-Technik (PF-Technik) aufgenommenen Messdatensatz fehlende, d.h., obwohl gemäß Nyquist für einen vollständigen Messdatensatz geforderte, nicht-aufgenommene, Messdaten ausgleichen, umfasst die Schritte:
- Empfang von auf Basis von Messdaten des Messdatensatzes erstellten Eingangsdaten,
- Anwendung wenigstens einer trainierten Ausgleichsfunktion auf die Eingangsdaten, wobei eine Ausgleichsinformation, welche in dem Messdatensatz fehlende Messdaten ausgleicht, umfassende Ausgangsdaten ermittelt werden,
- Bereitstellen der Ausgangsdaten.

## Beschreibung

Die Erfindung betrifft ein Partial-Fourier-Verfahren mit neuronalen Netzen.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch B₀―Feld genannt, mit Feldstärken von 0,2 Tesla bis 7 Tesla und mehr positioniert, so dass sich dessen Kernspins entlang des Grundmagnetfeldes orientieren. Zum Auslösen von als Signale messbaren Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder, kurz Gradienten genannt, überlagert. Ein verwendetes Schema, das eine zeitliche Abfolge von einzustrahlenden RF-Pulsen und zu schaltenden Gradienten beschreibt, wird als Pulssequenz(schema), oder auch kurz als Sequenz, bezeichnet. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen FourierTransformation ein zugehöriges MR-Bild rekonstruierbar.

Um bei MR-Messungen das Signal-zu-Rausch-Verhältnis (SNR, engl. "signal to noise ratio") zu verbessern oder eine Bewegungs- und/oder Flusssensitivität der Messung zu verringern, ist es bei vielen Aufnahmen bereits üblich, Messdaten mehrfach aufzunehmen, um Mittelungen an den Messdaten oder z.B. an den rekonstruierten Bilddaten vornehmen zu können (engl. "averaging").

Darüber hinaus ist es aber bei manchen Untersuchungen auch notwendig, mehrere, d. h. eine ganze Serie von Magnetresonanzaufnahmen des Untersuchungsobjekts, durchzuführen, wobei ein bestimmter Messparameter variiert wird. Anhand der Messungen wird die Wirkung dieses Messparameters auf das Untersuchungsobjekt beobachtet, um daraus dann später diagnostische Schlüsse zu ziehen. Unter einer Serie sind dabei zumindest zwei, in der Regel aber mehr als zwei Aufnahmen von Messdatensätzen zu verstehen. Sinnvollerweise wird dabei ein Messparameter so variiert, dass der Kontrast eines bei den Messungen angeregten bestimmten Materialtyps, beispielsweise eines Gewebetyps des Untersuchungsobjekts oder eines chemischen Stoffes, der signifikant für die meisten bzw. bestimmte Gewebetypen ist, wie z. B. Wasser, durch die Variation des Messparameters möglichst stark beeinflusst wird. Dies sorgt dafür, dass die Wirkung des Messparameters auf das Untersuchungsobjekt besonders gut sichtbar ist.

Ein typisches Beispiel für Serien von Magnetresonanzaufnahmen unter der Variation eines den Kontrast stark beeinflussenden Messparameters sind so genannte Diffusionsbildgebungsverfahren (englisch "Diffusion weighting imaging" (DWI)). Unter Diffusion versteht man die Brownsche Bewegung (englisch "brownian motion") von Molekülen in einem Medium. Bei der Diffusionsbildgebung werden in der Regel mehrere Bilder mit unterschiedlichen Diffusionsrichtungen und -wichtungen aufgenommen und miteinander kombiniert. Die Stärke der Diffusionswichtung wird meist durch den so genannten "b―Wert" definiert. Die Diffusionsbilder mit unterschiedlichen Diffusionsrichtungen und -wichtungen bzw. die daraus kombinierten Bilder können dann zu diagnostischen Zwecken verwendet werden. So können durch geeignete Kombinationen der aufgenommenen diffusionsgewichteten Bilder Parameterkarten mit besonderer diagnostischer Aussagekraft erzeugt werden, wie beispielsweise Karten, die den "Apparent Diffusion Coefficient (ADC)" oder die "Fractional Anisotropy (FA)" wiedergeben.

Bei der diffusionsgewichteten Bildgebung werden zusätzliche Gradienten, die eine jeweilige Diffusionsrichtung und eine jeweilige Diffusionswichtung wiederspiegeln, in eine Pulssequenz einfügt, um die Diffusionseigenschaften des Gewebes sichtbar zu machen oder zu messen. Diese Gradienten führen dazu, dass Gewebe mit schneller Diffusion (z.B. Zerebrospinalflüssigkeit, englisch "cerebral spinal fluid" CSF) einem stärkeren Signalverlust unterliegt als Gewebe mit langsamer Diffusion (z.B. die graue Substanz im Gehirn, englisch "grey matter"). Der daraus resultierende Diffusionskontrast wird klinisch immer bedeutender und Anwendungen gehen inzwischen weit über die klassische frühe Erkennung von ischämischem Schlaganfall (englisch "ischemic stroke") hinaus.

Häufig basiert die Diffussionsbildgebung auf der Echoplanarbildgebung (EPI, engl. "echo planar imaging") wegen der kurzen Akquisitionszeit der EPI Sequenz pro Bild und Ihrer Robustheit gegenüber Bewegung.

Mittels EPI-Verfahren aufgenommene MR-Bilder können lokale geometrische Verzerrungen aufweisen, welche z.B. durch Inhomogenitäten im Grundmagnetfeld verursacht sind. Die Inhomogenitäten können durch Suszeptibilitätssprünge an Gewebegrenzflächen, z.B. bei Übergängen von Luft zu Gewebe des Untersuchungsobjekts, beispielsweise bei menschlichen oder tierischen Patienten als Untersuchungsobjekt Übergänge von Knochen zu weicherem Gewebe, hervorgerufen werden, und führen zu lokalen Phasenakkumulationen über den Auslese-Echozug der EPI-Messung. Um die Stärke der geometrischen Verzerrungen zu minimieren kann versucht werden, die Phasenakkumulation zu minimieren. Dazu kann beispielsweise der Echozug möglichst kurz gehalten werden, was allerdings die räumliche Auflösung beschränkt, oder es können parallele Bildgebungstechniken eingesetzt werden. Weitere Effekte, wie Bewegungen auch pulsierende Bewegungen im Zielbereich des zu untersuchenden Untersuchungsobjektes, aus welchem Messdaten aufgenommen werden, können zu (weiteren) Phasenfehlern führen.

Es ist weiter möglich, den k-Raum in Segmenten aufzunehmen, d.h. die Aufnahme von Messdaten segmentiert vorzunehmen. Grundsätzlich kann die Segmentierung des k-Raums in Phasenkodierrichtung und/oder in Ausleserichtung erfolgen.

Die erstmals in dem Artikel von Porter und Heidemann "High Resolution Diffusion-Weighted Imaging Using Readout-Segmented Echo-Planar Imaging, Parallel Imaging and a Two-Dimensional Navigator-Based Reacquisition", MRM 62, 2009, S.468-475, beschriebene RESOLVE-Sequenz ist eine Variante einer EPIartigen Sequenz, bei der eine Segmentierung in Ausleserichtung statt in Phasenkodierrichtung erfolgt. Eine RESOLVE-Sequenz kann mit einer Diffusionspräparation und/oder mit Navigatormessungen kombiniert werden.

Allgemein gesagt, kann bei einer RESOLVE-Sequenz nach einer Diffusionspräparation durch einen Prephasierungsgradienten dasjenige Segment des k-Raums das in der folgenden Auslesephase mit Messdaten befüllt werden soll, festgelegt werden. In der Auslesephase wird mittels eines sinusförmigen Auslesegradienten ein Zug an Echosignalen als Messdaten für das festgelegte Segment erfasst. Mittels eines weiteren Gradienten, der eine dem Prephasiergradienten entgegengesetzte Polarität aufweist und im Anschluss an der Auslesephase geschaltet werden kann, kann in Ausleserichtung wieder zu dem k-Raumzentrum zurückgekehrt werden, bevor ein weiterer Refokussierungspuls eingestrahlt werden kann, der zur Ausbildung weiterer Echosignale führt, die mittels eines Navigatorauslesegradienten als Navigatordaten des k-Raumzentrums erfasst werden. Die somit für jedes Segment erfassten Navigatordaten können verwendet werden, um mögliche Phasenveränderungen zwischen dem Erfassen der Messdaten in den einzelnen Segmenten auszugleichen, wie es in dem bereits oben genannten Artikel von Porter und Heidemann genauer beschrieben ist.

Zur Verkürzung der Dauer einer Aufnahme eines gemäß Nyquist vollständigen Messdatensatzes können unter bestimmten Bedingungen bestimmte Messdaten des vollständigen Satzes nicht aufgenommen, sondern später ergänzt werden. Für die Aufnahme eines unvollständigen Messdatensatzes wird weniger Zeit benötigt als für eine Aufnahme eines vollständigen Messdatensatzes. Ein derartiges Verfahren ist beispielsweise eine partielle Fourier-Technik (PF, englisch: "partial Fourier"). Bei PF-Techniken wird üblicherweise nicht der gesamte k-Raum, sondern, in eine k-Raumrichtung (PF-Richtung) nur ein durch einen PF-Faktor angegebener und weiter durch Symmetriebetrachtungen des k-Raums bestimmter Teil des k-Raums abgetastet, also aufgenommen oder gemessen. Die Symmetrie des k-Raums wird bei PF-Techniken genutzt, um mit Hilfe unterschiedlicher Rekonstruktionsmethoden den nicht gemessenen Teil des k-Raums zu ergänzen oder aufzufüllen. Bei einer als "zero-filling" bezeichneten Methode, werden nicht aufgenommene Bereiche des k-Raums durch Nullen oder Nullwerte aufgefüllt. Dies ist eine sehr einfache Methode, die wenig Rechenleistung erfordert, die aber nicht immer befriedigende Ergebnisse liefert.

Eine alternative Methode, um nicht-aufgenommene Messdaten bei PF-Verfahren zu ergänzen, nutzt einen sogenannten POCS-Algorithmus (englisch: "Projection Onto Convex Sets"), welcher fehlende, also nicht gemessene Teile des k-Raums eines Messdatensatzes in einem iterativen Prozess abschätzt und dabei eine Datenkonsistenz mit den tatsächlich gemessenen Teilen des k-Raums des Messdatensatzes, also tatsächlich gemessenen k-Raum-Werten, sicherstellt. Hierzu sei beispielsweise auf die Veröffentlichung "Implementation and Assessment of Diffusion-Weighted Partial Fourier Readout-Segmented Echo-Planar Imaging" von Robert Frost et.al. in Magnetic Resonance in Medicine 68:441-451 (2012) verwiesen. Diese Methodik kann zu einer verbesserten Schärfe oder Ortsauflösung führen, ist jedoch nicht immer zuverlässig anwendbar, beispielsweise abhängig von bestimmten Phasenvariationen in dem zugrunde liegenden Messdatensatz.

Gerade bei segmentierten Aufnahmetechniken, wie insbesondere die oben genannte, für Phasenveränderungen anfällige RESOLVE-Technik, können in den Messdatensätzen enthaltene Phaseninkonsistenzen zwischen den einzelnen Segmenten in Verbindung mit PF-Techniken zu Artefakten, insbesondere sogenannten Ringing-Artefakten und/oder gitterartigen Mesh-Artefakten, führen, insbesondere bei höheren PF-Faktoren. Dadurch wird eine mittels einer PF-Technik erzielbare Beschleunigung der Messdatenaufnahme oftmals limitiert.

Der Erfindung liegt die Aufgabe zugrunde, Artefakte in Verbindung mit PF-Verfahren zu verhindern, und dabei größerer PF-Faktoren zu erlauben, um eine für die Messdatenaufnahme erforderliche Messzeit weiter reduzieren zu können. Dazu soll es insbesondere ermöglicht werden, das Fehlen von Messdaten in einem mittels einer PF-Technik aufgenommenen Messdatensatz ausgleichen zu können, so als wären für einen mittels PF-Technik aufgenommenen Messdatensatz nicht um einen PF-Faktor in PF-Richtung reduziert Messdaten aufgenommen worden, sondern alle, so als wäre der Messdatensatz in PF-Richtung gemäß Nyquist vollständig abgetastet worden.

Die Aufgabe wird gelöst durch ein Verfahren zum Erstellen von Ausgleichsdaten gemäß Anspruch 1, ein Verfahren zum Vermeiden von Artefakten in aus einem mittels einer PF-Technik aufgenommenen Messdatensatz rekonstruierten Bilddaten gemäß Anspruch 11, eine Ausgleichseinrichtung gemäß Anspruch 12, eine Magnetresonanzanlage gemäß Anspruch 13, ein Computerprogramm gemäß Anspruch 14, sowie einen elektronisch lesbaren Datenträger gemäß Anspruch 15.

Ein erfindungsgemäßes computerimplementiertes Verfahren zum Erstellen von Ausgleichsdaten, welche in einem mittels einer partiellen Fourier-Technik (PF-Technik) aufgenommenen Messdatensatz fehlende, d.h., obwohl gemäß Nyquist für einen vollständigen Messdatensatz geforderte, nicht-aufgenommene, Messdaten ausgleichen, umfasst die Schritte:
- Empfang von auf Basis von Messdaten des Messdatensatzes erstellten Eingangsdaten,
- Anwendung wenigstens einer trainierten Ausgleichsfunktion auf die Eingangsdaten, wobei eine Ausgleichsinformation, welche in dem Messdatensatz fehlende Messdaten ausgleicht, umfassende Ausgangsdaten ermittelt werden,
- Bereitstellen der Ausgangsdaten.

Das erfindungsgemäße Ausgleichsverfahren erlaubt somit ein Ausgleichen von in einem geladenen Messdatensatz durch Verwendung einer PF-Technik fehlenden Messdaten verursachten Effekten durch Bereitstellen von Ausgleichsinformationen umfassenden Ausgangsdaten. Die Ausgleichsinformation kann hierbei je nach Art der Ausgangsdaten unterschiedlich ausgestaltet sein, jedoch bewirkt sie jeweils einen Ausgleich der fehlenden Messdaten, sodass mittels der Ausgangsdaten die fehlenden Messdaten, direkt oder indirekt, ersetzt werden können, so als wären sie aufgenommen worden. Insbesondere durch durch eine PF-Technik nicht-aufgenommene und somit fehlende Messdaten verursachte Artefakte in Bilddaten können so vermieden werden, wobei gleichzeitig eine erreichbare Bildschärfe erhöht wird.

Erfindungsgemäß wird mithin vorgeschlagen, künstliche Intelligenz, insbesondere eines oder mehrere neuronale Netze, einzusetzen, um ein schnelles und zuverlässiges Ausgleichen von fehlenden Messdaten in mittels einer PF-Technik aufgenommenen Messdatensätzen zu erreichen. Auf diese Weise ist mithin ein automatisiertes Ausgleichen von durch die PF-Technik nicht-aufgenommenen Informationen auch bei höheren PF-Faktoren möglich, wodurch eine zur Aufnahme der Messdaten benötigte Messzeit reduziert werden kann, ohne eine Bildqualität von auf Basis der aufgenommenen Messdaten rekonstruierten Bilddaten zu verringern, sondern sogar die Bildqualität zu verbessern.

Im Allgemeinen bildet eine trainierte Funktion, so mithin auch die trainierte Ausgleichsfunktion, kognitive Funktionen ab, die Menschen anderen menschlichen Gehirnen assoziieren.

Durch Training basierend auf Trainingsdaten (Maschinenlernen) ist die trainierte Funktion in der Lage, sich an neue Umstände anzupassen und Muster zu detektieren und zu extrapolieren.

Allgemein gesagt können Parameter einer trainierten Funktion durch Training angepasst werden. Insbesondere können überwachtes Lernen, halbüberwachtes Lernen, nicht überwachtes Lernen, Reinforcement Learning und/oder aktives Lernen verwendet werden. Darüber hinaus kann auch Repräsentationslernen (auch als "Feature Learning" bekannt) eingesetzt werden. Die Parameter der trainierten Funktion können insbesondere iterativ durch mehrere Trainingsschritte angepasst werden.

Eine trainierte Funktion kann beispielsweise ein neuronales Netz, eine Support Vector Machine (SVM), einen Entscheidungsbaum und/oder ein Bayes-Netzwerk umfassen und/oder die trainierte Funktion kann auf k-means-Clustering, Q-Lernen, genetischen Algorithmen und/oder Zuordnungsregeln basieren. Insbesondere kann ein neuronales Netzwerk, ein tiefes neuronales Netzwerk, ein Convolutional Neural Network (CNN) insbesondere ein nur aus Faltungslayern bestehendes CNN, oder ein tiefes CNN sein. Darüber hinaus kann das neuronale Netzwerk ein Adversarial Network, ein tiefes Adversarial Network und/oder ein Generative Adversarial Network (GAN) sein.

Mit besonderem Vorteil kann die trainierte Ausgleichsfunktion ein Convolutional Neural Network (CNN) umfassen. Mit besonderem Vorteil kann es sich bei dem CNN um ein U-förmiges neuronales Netz, insbesondere ein U-Net, oder ein (umgekehrt U-förmiges) Up-Down-Netz handeln. Derartige (umgekehrt) U-förmige Netze haben sich bei Bildverarbeitung, insbesondere bei Bild-zu-Bild-Netzen, bewährt. Selbstverständlich können jedoch auch andere Netzwerkarchitekturen herangezogen werden.

Allgemein kann gesagt werden, dass CNNs, auch solche, die als trainierte Ausgleichsfunktion eingesetzt werden können, eine Faltungsbasis zur Erzeugung von Merkmalen aus den Eingangsdaten, insbesondere aus mittels Magnetresonanztechnik aufgenommenen Messdatensätzen ermittelten Eingangsdaten, aufweisen, welche insbesondere Faltungsschichten und Pooling-Schichten umfassen kann. Der Faltungsbasis folgt dann üblicherweise ein Klassifizierer, der eine oder mehrere vollständig verbundene Schichten (Fully Connected Layers) enthalten kann. Das Hauptziel des Klassifizierers ist die Klassifizierung der Eingangsdaten basierend auf den mittels der Faltungsbasis extrahierten Merkmalen. Mit anderen Worten folgt auf eine Merkmalsextraktion in der Faltungsbasis eine Klassifizierung im Klassifizierer, um die Ausgangsdaten bereitzustellen. Beispielsweise ein U-Net konvertiert die Eingangsdaten über die Faltungsbasis zur Merkmalsextraktion in einen Vektor ("down") und über eine gleiche Faltungsbasis zurück, die Auflösung wieder erhöhend, in den Eingangsdaten entsprechende Daten ("up"). Dadurch wird die Struktur der Eingangsdaten in den Ausgangsdaten erhalten, wodurch z.B. Verzerrungen in Bilddaten als Eingangsdaten und Ausgangsdaten vermieden werden. Ein Up-Down-Netz geht umgekehrt zu einem U-Net vor und erhöht zunächst die Auflösung ("up") auf einer Faltungsbasis, um dann eine Merkmalsextraktion ("down") durchzuführen, wobei ebenfalls die Struktur der Eingangsdaten der Struktur der Ausgangsdaten entspricht. Mittels einem derartig die Struktur erhaltenden Netz können in den Ausgangsdaten Informationen für Unterbereiche der Struktur dargestellt werden, z.B. bei Bilddaten als Eingangsdaten können pixelweise Informationen in den entsprechenden Ausgangsdaten dargestellt werden.

In einer ersten konkreten Ausgestaltung der vorliegenden Erfindung kann vorgesehen sein, dass wenigstens eine trainierte Ausgleichsfunktion verwendet wird, die einen aus dem aufgenommenen Messdatensatz rekonstruierten Bilddatensatz als Eingangsdaten erhält, und einen Bilddatensatz als Ausgangsdaten bereitstellt, in dem die Bildschärfe gegenüber den Eingangsdaten erhöht ist, so als wäre der geladene Messdatensatz in PF-Richtung vollständig abgetastet worden. Die erhöhte Bildschärfe entspricht somit einer Bildschärfe wie sie bei Rekonstruktion von Bilddatensätzen aus in PF-Richtung vollständig abgetasteten Messdatensätzen erreicht wird.

In einer zweiten konkreten Ausgestaltung der vorliegenden Erfindung kann vorgesehen sein, dass wenigstens eine trainierte Ausgleichsfunktion verwendet wird, die einen aus dem aufgenommenen Messdatensatz rekonstruierten Bilddatensatz als Eingangsdaten erhält, und einen Bilddatensatz als Ausgangsdaten bereitstellt, der einem Satz an Differenzbilddaten entspricht, welcher eine Differenz eines Bilddatensatzes in dem die Bildschärfe gegenüber den Eingangsdaten erhöht ist, so als wäre der geladene Messdatensatz in PF-Richtung vollständig abgetastet worden, und der Eingangsdaten ist. Auf diese Weise wird die trainierte Ausgleichsfunktion auf die Differenzen zwischen einem aus dem geladenen Messdatensatz rekonstruierten Bilddatensatz und einem Bilddatensatz mit erhöhter Bildschärfe wie sie bei Rekonstruktion von Bilddatensätzen aus in PF-Richtung vollständig abgetasteten Messdatensätzen erreicht wird, fokussiert trainiert, wodurch Bildartefakten besonders gut vermieden werden können. Weiterhin kann bei Betrachtung von Differenzdaten besonders leicht eine Konsistenzprüfung der Ausgangsdaten mit den Eingangsdaten als Plausibilitätsprüfung der Ausgangsdaten durchgeführt werden. Ein Bilddatensatz mit erhöhter Bildschärfe kann dann durch Kombination der Eingangsdaten mit den Ausgangsdaten erhalten werden.

Für die erste und die zweite Ausgestaltung kann vorgesehen sein, dass die trainierte Ausgleichsfunktion mit Trainingseingangsdaten und Trainingsausgangsdaten trainiert wird, die aus vollständig (gemäß Nyquist) aufgenommenen Messdatensätzen gewonnen wurden. Für ein Erzeugen von Trainingseingangsdaten können hier wieder in einem geladenen vollständigen Messdatensatz in eine PF-Richtung Messdaten entfernt werden, bevor aus einem so erhaltenen reduzierte Messdatensatz ein Bilddatensatz als Trainingseingangsdaten erzeugt wird. Eine Erzeugung von Trainingseingangsdaten kann somit ein Laden von vollständig abgetasteten Messdatensätzen, und ein Entfernen von Messdaten, z.B. in einer einem gewünschten PF-Faktor entsprechenden Anzahl von Segmenten des Messdatensatzes, umfassen. Weiterhin kann das Erzeugen von Trainingseingangsdaten ein Spiegeln oder eine komplexe Konjugation des k-Raums von Messdatensätzen, denen bereits Messdaten entfernt wurden oder aus denen noch Messdaten entfernt werden, umfassen. Trainingsausgangsdaten können erzeugt werden, indem aus den vollständig aufgenommenen Messdaten, aus welchen Trainingseingangsdaten erzeugt wurden, ein Bilddatensatz rekonstruiert wird, der ggf. mit aus den erzeugten Trainingseingangsdaten rekonstruierten Bilddaten zu Differenzdaten verarbeitet wird.

In einer dritten Ausgestaltung der vorliegenden Erfindung kann vorgesehen sein, dass wenigstens eine trainierte Ausgleichsfunktion verwendet wird, die aus dem aufgenommenen Messdatensatz rekonstruierten Hybridraumdaten als Eingangsdaten erhält, und Hybridraumdaten als Ausgangsdaten bereitstellt, in dem die Bildschärfe in PF-Richtung gegenüber den Eingangsdaten erhöht ist, so als wäre der geladene Messdatensatz in PF-Richtung vollständig abgetastet worden. Durch eine Verwendung von Hybridraumdaten als Eingangsdaten und Ausgangsdaten wird die trainierte Ausgleichsfunktion auf die Richtung der Raumkomponente, bevorzugt die durch die PF-Technik nicht-vollständig abgetastete Richtung, konzentriert. Bilddatensätze mit erhöhter Bildschärfe können aus den Hybridraumdaten rekonstruiert werden, z.B. durch eine weitere Fouriertransformation in die Richtung der noch im k-Raum liegenden Dimension der Hybridraumdaten.

Für diese dritte Ausgestaltung kann vorgesehen sein, dass die trainierte Ausgleichsfunktion mit Trainingseingangsdaten und Trainingsausgangsdaten trainiert wird, die aus vollständig (gemäß Nyquist) aufgenommenen Messdatensätzen gewonnen wurden. Für ein Erzeugen von Trainingseingangsdaten können hier wieder in einem geladenen vollständigen Messdatensatz in eine PF-Richtung Messdaten entfernt werden, bevor ein so erhaltener reduzierter Messdatensatz, z.B. durch eine Fouriertransformation in PF-Richtung, in Hybridraumdaten überführt wird. Eine Erzeugung von Trainingseingangsdaten kann hier wieder ein Laden von vollständig abgetasteten Messdatensätzen, und ein Entfernen von Messdaten, z.B. in einer einem gewünschten PF-Faktor entsprechenden Anzahl von Segmenten des Messdatensatzes, umfassen. Weiterhin kann das Erzeugen von Trainingseingangsdaten ein Spiegeln oder eine komplexe Konjugation des k-Raums von Messdatensätzen, denen bereits Messdaten entfernt wurden oder aus denen noch Messdaten entfernt werden, umfassen. Trainingsausgangsdaten können erzeugt werden, indem aus den vollständig aufgenommenen Messdaten, aus welchen Trainingseingangsdaten erzeugt wurden, Hybridraumdaten, z.B. durch eine gleiche Fouriertransformation, erstellt werden. Es ist auch denkbar Trainingsausgangsdaten zu erzeugen, indem in dem ursprünglich geladenen vollständigen Messdatensatz entfernte Messdaten in Hybridraumdaten als Trainingsausgangsdaten überführt werden. Durch die Erzeugung von Trainingsausgangsdaten aus in dem ursprünglich geladenen vollständigen Messdatensatz entfernten Messdaten können, durch unterschiedliche Auswahl, der für die Erzeugung der Trainingsausgangsdaten verwendeten, entfernten Messdaten, eine erhöhte Anzahl von Trainingsausgangsdaten erzeugt werden.

In einer vierten Ausgestaltung der vorliegenden Erfindung kann vorgesehen sein, dass wenigstens eine trainierte Ausgleichsfunktion verwendet wird, die aus verschiedenen Bereichen eines aus einem aufgenommenen Messdatensatz rekonstruierte Bilddatensätze bzw. Sätze an Hybridraumdaten bzw. Messdaten (im k-Raum) als Eingangsdaten erhält, und Bilddatensätze bzw. Sätze von Hybridraumdaten bzw. Messdaten (im k-Raum) von in dem aufgenommenen Messdatensatz fehlenden Bereichen oder von den in dem aufgenommenen Messdatensatz aufgenommenen und nicht-aufgenommenen Messdaten als Ausgangsdaten bereitstellt. Der geladenen Messdatensatz kann hierbei insbesondere bereits segmentweise aufgenommen worden sein, wobei ein Segment der segmentweisen Aufnahme des Messdatensatzes mit einem zur Erzeugung von Eingangsdaten verwendeten Bereich übereinstimmen kann, aber nicht muss. Durch eine Verwendung von Bereichen, die auch nur eine k-Raumlinie umfassen können, des aufgenommenen Messdatensatzes bei der Erzeugung der Eingangsdaten können Fehler, die bei einer Kombination einzelner Bereiche eines aufgenommenen Messdatensatzes entstehen können, ohne weitere ansonsten anzuwendende (Segment-)Fittingverfahren vermieden werden. In einer Variante dieser Ausgestaltung können die Eingangsdaten direkt die in dem geladenen Messdatensatz vorhandenen gemessenen Messdaten sein und die Ausgangsdaten die in dem geladenen Messdatensatz fehlenden Messdaten oder ein zu einem vollständigen Messdatensatz ergänzter Messdatensatz sein.

Für diese vierte Ausgestaltung kann vorgesehen sein, dass die trainierte Ausgleichsfunktion mit Trainingseingangsdaten und Trainingsausgangsdaten trainiert wird, die aus vollständig (gemäß Nyquist) segmentweise aufgenommenen Messdatensätzen gewonnen wurden, deren Segmente durch einen Segment-Fitting-Algorithmus in Übereinstimmung gebracht wurden. Weitere Trainingseingangsdaten und/oder Trainingsausgangsdaten können aus unterschiedlich gefitteten Messdatensätzen erzeugt werden, die z.B. durch ein, insbesondere manuelles oder semiautomatisches, Nachjustieren der Ergebnisse eines ursprünglich verwendeten Segment-Fitting-Algorithmus erzeugt werden. Ansonsten kann analog zu den vorhergehenden Ausgestaltungen vorgegangen werden.

Eine zweckmäßige, allgemeine Weiterbildung der Erfindung kann vorsehen, dass die Eingangsdaten weiterhin, d.h. zusätzlich, Navigatordaten umfassen, welche dem geladenen Messdatensatz zugeordnet sind. Dadurch können, z.B. in den Navigatordaten enthaltene Informationen über eine bei der Aufnahme des Messdatensatzes herrschende Phasenlage, z.B. eine Hintergrundphase, mit in der trainierten Ausgleichsfunktion verwertet werden. Dadurch kann eine Stabilisierung der Ausgangsdaten erreicht werden, z.B. auch wenn starke Phasenvariationen zwischen einzelnen aufgenommenen Segmenten des aufgenommenen Messdatensatzes bestehen.

Mithin kann mit dem erfindungsgemäßen Verfahren ein PF-Faktor, mit welchem Messdatensätze aufgenommen werden, gegenüber bisherigen Verfahren erhöht und damit die zur Aufnahme eines Messdatensatzes benötigte Zeitdauer verringert werden, wobei eine durch ein erfindungsgemäßes Verfahren erreichte Bildqualität von auf Basis von Messdaten eines geladenen Messdatensatzes und zugehörigen geladenen Ausgangsdaten rekonstruierten Bilddatensätzen trotzdem nicht sinkt, sondern sogar ebenfalls erhöht ist. Hierbei kommt eine trainierte Ausgleichsfunktion, beispielsweise in einer U-Net-Architektur, zum Einsatz.

Neben dem Verfahren betrifft die Erfindung auch eine Ausgleichseinrichtung zum Erstellen von Ausgleichsdaten, welche in einem mittels einer PF-Technik aufgenommenen Messdatensatz fehlende Messdaten ausgleichen, aufweisend
- eine erste Schnittstelle zum Empfang von auf Basis von Messdaten des Messdatensatzes erstellten Eingangsdaten,
- eine Ausgleichseinheit zur Anwendung wenigstens einer trainierten Ausgleichsfunktion auf die Eingangsdaten, wobei eine Ausgleichsinformation umfassende Ausgangsdaten ermittelt werden, und
- eine zweite Schnittstelle (43) zum Bereitstellen der Ausgangsdaten, wobei die Ausgleichseinrichtung derart ausgestaltet ist, dass sie ein hierin beschriebenes Verfahren durchführt.

Mit anderen Worten ist die Ausgleichseinrichtung, welche im Allgemeinen wenigstens einen Prozessor und/oder wenigstens ein Speichermittel umfasst, zur Durchführung des erfindungsgemäßen Ausgleichsverfahrens ausgebildet. Sämtliche Ausführungen bezüglich des erfindungsgemäßen Verfahrens lassen sich analog auf die erfindungsgemäße Ausgleichseinrichtung übertragen, mit welcher mithin ebenso die bereits genannten Vorteile erhalten werden können.

Die Ausgleichseinrichtung kann beispielsweise als Teil einer Auswerteeinrichtung implementiert werden. Beispielsweise kann die Ausgleichseinrichtung als Teil einer Steuereinrichtung einer Magnetresonanzanlage verwendet werden, um insbesondere in der Nachverarbeitung (im Postprocessing) aufgenommener Messdaten eingesetzt zu werden. Andere Ausgestaltungen sind selbstverständlich denkbar.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Ausgleichseinrichtung.

Ein erfindungsgemäßes Computerprogramm ist direkt in einen Speicher einer Recheneinrichtung, insbesondere einer Ausgleichseinrichtung, ladbar, und weist Programmmittel auf, um die Schritte eines erfindungsgemäßen Verfahrens durchzuführen, wenn das Computerprogramm auf der Recheneinrichtung ausgeführt wird. Das Computerprogramm kann auf einem erfindungsgemäßen elektronisch lesbaren Datenträger gespeichert sein, der mithin darauf gespeicherte Steuerinformationen umfasst, die wenigstens ein erfindungsgemäßes Computerprogramm umfassen und bei Verwendung des Datenträgers in einer Recheneinrichtung diese dazu ausgestalten, das erfindungsgemäße Verfahren auszuführen. Bei dem Datenträger kann es sich insbesondere um einen nicht transienten Datenträger, beispielsweise eine CD-ROM oder einen USB-Stick, handeln.

Die in Bezug auf das Verfahren und/oder die Ausgleichseinrichtung angegebenen Vorteile und Ausführungen gelten analog auch für die Magnetresonanzanlage, das Computerprogrammprodukt und den elektronisch lesbaren Datenträger. Für einen beanspruchten Gegenstand beschriebene Merkmale, Vorteile und Varianten können auf andere beanspruchte Gegenstände übertragen werden. Mit anderen Worten können auf Vorrichtungen/Einheiten gerichtete Ansprüche können durch Merkmale verbessert werden, die mit Bezug auf das Verfahren genannt wurden.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar und andere Variationen können vom Fachmann hieraus abgeleitet werden, ohne den Schutzumfang der Erfindung zu verlassen. Es zeigen:
Fig. 1 ein schematisches Ablaufdiagram eines erfindungsgemäßen Verfahrens,
Fig. 2 schematisch dargestellte Beispiele für im k-Raum mittels einer PF-Technik aufgenommene Messdaten eines Messdatensatzes,
Fig. 3 schematisch die Struktur einer trainierten Ausgleichsfunktion,
Fig. 4 eine erfindungsgemäße Zuordnungseinrichtung,
Fig. 5 eine schematisch dargestellte erfindungsgemäße Magnetresonanzanlage.

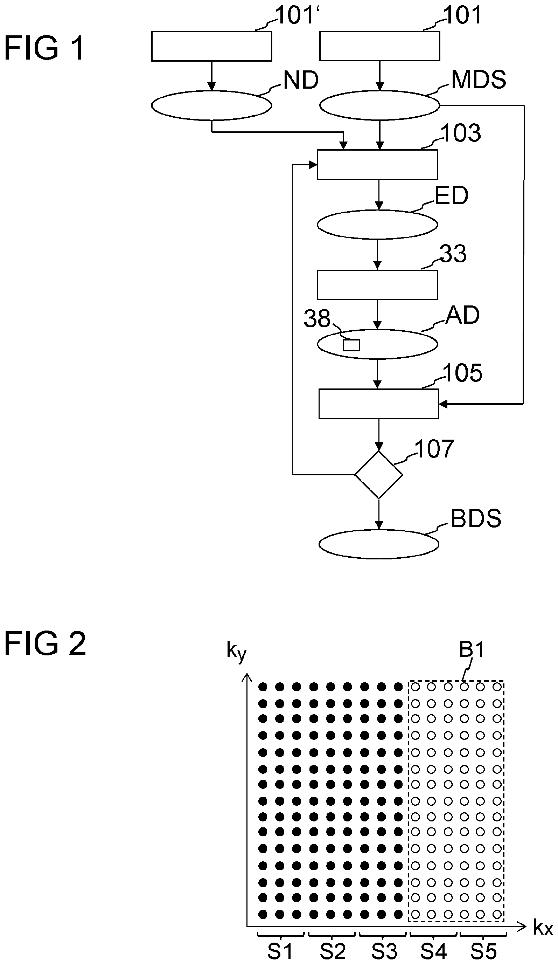

Figur 1 ist ein schematisches Ablaufdiagramm eines erfindungsgemäßen Verfahrens zur Vermeidung von Artefakten in aus einem mittels einer PF-Technik aufgenommenen Messdatensatz MDS rekonstruierten Bilddaten BDS.

Dabei wird ein mittels einer PF-Technik aufgenommener Messdatensatz MDS geladen (Block 101).

Zur Aufnahme des Messdatensatzes MDS kann der k-Raum in eine k-Raumrichtung segmentiert, beispielsweise gemäß einem in Figur 2 schematisch dargestellten Abtastschemas abgetastet werden. Der gemäß Nyquist abzutastende k-Raum ist jeweils durch Kreise dargestellt. Dabei entsprechen ausgefüllte Kreise abgetasteten k-Raumpunkten, zu welchen somit Messdaten aufgenommen wurden, und unausgefüllt dargestellte Kreise nichtabgetasteten k-Raumpunkten, die in dem Bereich B1 liegen, und zu welchen somit Messdaten fehlen.

In dem gezeigten Beispiel wird 3/5 des k-Raums aufgenommen, der PF-Faktor ist somit PF=3/5. Die PF-Richtung entspricht der Ausleserichtung kx. In Phasenkodierrichtung ky kann der k-Raum, für k-Raumlinien, in welchen Messdaten aufgenommen werden, vollständig abgetastet werden. Es ist auch denkbar, dass in Phasenkodierrichtung ky zusätzlich ein grundsätzlich bekanntes paralleles Akquisitionsverfahren (kurz "ppa-Verfahren"), wie z.B. GRAPPA, eingesetzt wird, wodurch die zur Aufnahme der Messdaten weiter beschleunigt werden kann.

Die Aufnahmen der Messdaten eines Messdatensatzes MDS kann in Segmenten erfolgen. Dabei könnten z.B. die skizzierten Segmente S1, S2, S3, S4 und S5, derart aufgenommen werden, dass in nur die Segmente S1, S2 und S3 aufgenommen werden und in den Segmenten S4 und S5 nicht. Die Segmente S4 und S5 entsprechen somit dem Bereich B1 fehlender Messdaten. Der Messdatensatz MDS kann insbesondere mittels einer RESOLVE-Technik aufgenommen werden. Bei Verwendung einer RESOLVE-Technik ist das Relaxationsverhalten (T2/T2*-Zerfall), dem die in den verschiedenen Segmenten aufgenommenen Messdaten unterliegen, jeweils für alle Segmente gleich. Daher eignen sich RESOLVE-Techniken besonders gut, um in Verbindung mit auf Symmetrie-überlegungen basierende PF-Techniken eingesetzt zu werden, insbesondere im Vergleich zu anderen, weniger in PF-Richtung symmetrischen Aufnahmetechniken, wie z.B. EPI. Bei Verbindung von einer RESOLVE-Technik mit einer PF-Technik kann durch die segmentierte Aufnahme direkt Messzeit eingespart werden, da durch die PF-Technik weniger Segmente aufgenommen werden (bei gleicher Wiederholzeit TR für jedes Segment). Bei Kombinationen von EPI-Techniken mit PF-Techniken wird in der Regel nicht schon bei der Aufnahme der Messdaten Messzeit eingespart, da hier die Wiederholzeit TR eher nicht verkürzt wird (da sie auch Einfluss auf den Kontrast eines resultierenden Bilddatensatzes hat). Dafür kann aber eine Reduktion von Echozeiten TE und/oder eine Reduktion von Blurring-Artefakten erreicht werden, da der EPI-Echozug durch die PF-Technik verkürzt werden kann.

Der geladenen Messdatensatz MDS kann ein unter Verwendung eines parallelen Akquisitionsverfahrens, wie z.B. GRAPPA, mit einer Beschleunigung in einer ppa-Richtung, die nicht die PF-Richtung ist, aufgenommener Messdatensatz sein. Ein unter Verwendung eines parallelen Akquisitionsverfahrens aufgenommener Messdatensatz kann auch gemäß dem verwendeten parallelen Akquisitionsverfahren zunächst in ppa-Richtung ergänzt werden, und der so ergänzte Messdatensatz als Messdatensatz MDS für ein hier beschriebenes Verfahren geladen werden.

Der geladenen Messdatensatz MDS kann ein, insbesondere im Rahmen einer Diffusionsgewichteten MR-Messung, unter Verwendung einer EPI-Technik, insbesondere einer RESOLVE-Technik, aufgenommener Messdatensatz sein. Ein unter Verwendung einer EPI-Technik aufgenommener Messdatensatz kann mit für EPI-Techniken bekannten Phasenkorrekturverfahren korrigiert werden, und der so korrigierte Messdatensatz als Messdatensatz MDS für ein hier beschriebenes Verfahren geladen werden.

Auf Basis von Messdaten des geladenen Messdatensatzes MDS werden Eingangsdaten ED für eine trainierte Ausgleichsfunktion 33 erstellt (Block 103). Es können auch im Rahmen der Aufnahme des geladenen Messdatensatzes MDS aufgenommene Navigatordaten ND geladen werden (Block 101'), welche weitere Informationen über das mit dem geladenen Messdatensatz MDS gemessene Untersuchungsobjekt, insbesondere über während der Aufnahme des geladenen Messdatensatzes MDS herrschende Phasenlagen, umfassen. Erzeugte Eingangsdaten ED können auch Navigatordaten ND umfassen.

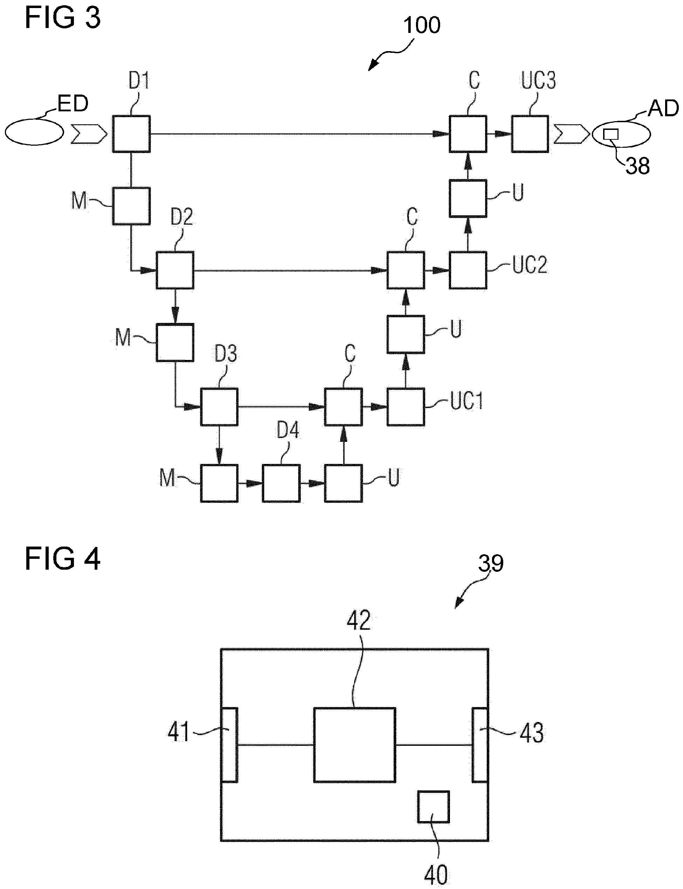

Die mit Bezug auf Figur 3 ausführlicher beschriebene Ausgleichsfunktion 33 stellt Ausgangsdaten AD bereit, welche eine Ausgleichsinformation 38 umfassen, die ebenfalls geladen werden.

Auf Basis von Messdaten des geladenen Messdatensatzes MDS und den geladenen Ausgangsdaten AD wird, ggf. nach einer Konsistenzprüfung 107, ein Bilddatensatz BDS erstellt (Block 105).

Eine Konsistenzprüfung 107 kann z.B. einen Vergleich und/oder ein Mitteln von in den Eingangsdaten ED umfassten Daten und diesen entsprechenden Daten der Ausgangsdaten AD umfassen.

Zusätzlich oder alternativ kann anhand von Messdaten des geladenen Messdatensatzes, die z.B. in einem bezüglich der gemessenen Frequenzen gleichen (hochfrequenten) Bereich im k-Raum gemessen wurden (im Beispiel der Figur 2, etwa die Segmente S1 und S2), in welchem auch nicht-gemessene Messdaten des Messdatensatzes liegen( im Beispiel der Figur 2, etwa die Segmente S4 und S5), eine zu erwartenden k-Raum-Energie der fehlenden Messdaten berechnet werden und mit einer entsprechenden k-Raum-Energie der Ausgangsdaten (z.B. bei fehlenden Messdaten als Ausgangsdaten oder bei Differenzbilddaten als Ausgangsdaten) verglichen werden.

Wird bei der Konsistenzprüfung 107 eine Abweichung der Daten der Eingangsdaten von den entsprechenden Daten der Ausgangsdaten festgestellt, die z.B. größer als ein vorgegebener Schwellwert ist, können die Ausgangsdaten verworfen werden und/oder erneut Eingangsdaten ED erzeugt und der Ausgleichsfunktion 33 zugeführt werden.

Fig. 3 zeigt eine beispielhafte Grundstruktur der trainierten Ausgleichsfunktion 33, vorliegend als U-Net, welche Eingangsdaten ED empfängt und Ausgangsdaten AD bereitstellt. Die Ausgleichsfunktion 33 umfasst in dem dargestellten Beispiel somit ein faltendes U-förmiges neuronales Netz 100. In einer anderen Variante kann die Ausgleichsfunktion 33 auch ein anderes (faltendes) neuronales Netz, z.B. ein Up-Down-Netz, umfassen (nicht dargestellt).

Bei dem in Figur 3 gezeigten U-förmigen neuronalen Netz 100 handelt es sich um ein "convolutional neural network", CNN oder faltendes neuronales Netz. Bei deren U-förmigen Architektur, wird eine erste Hälfte (absteigender Ast, "down") des Netzwerkes für die Merkmalsextraktion und eine zweite Hälfte (aufsteigender Ast, "up") für die Erhöhung der Auflösung verwendet. Wie bei derartigen U-Netzarchitekturen bekannt, weist die Ausgleichsfunktion 33 verschiedene Faltungen zur Reduzierung der Auflösungen auf, dargestellt als D1 bis D3 ("down convolution"), wobei dazwischen eine Maximalextraktion ("max pooling") stattfindet, mit M dargestellt in Fig. 3. Im aufsteigenden Ast sind U Komponenten ("up sampling") und UC Komponenten ("up convolution") vorgesehen, sowie Verknüpfungsschritte mit C dargestellt (concatenate).

Die trainierte Ausgleichsfunktion 33 wurde mit Trainingsdaten trainiert.

Dabei kann ein computerimplementiertes Verfahren zur Bereitstellung der trainierten Ausgleichsfunktion eingesetzt werden, welches die Schritte umfasst:
- Empfangen von Trainingseingangsdaten,
- Empfangen von Trainingsausgangsdaten, wobei die Trainingsausgangsdaten in einer Beziehung zu den Trainingseingangsdaten stehen, z.B. von gleicher oder verwandter Art sind, oder Trainingseingangsdaten und Trainingsausgangdaten aus Daten gleicher oder verwandter Art ermittelt sind,
- Trainieren einer Funktion basierend auf den Trainingseingangsdaten und den Trainingsausgangsdaten,
- Bereitstellen der trainierten Funktion als trainierte Ausgleichsfunktion.

Ein computerimplementiertes Verfahren zum Erstellen von Ausgleichsdaten, welche in einem mittels einer PF-Technik aufgenommenen Messdatensatz fehlende Messdaten ausgleichen, können Eingangsdaten ED empfangen werden, welche auf Basis von Messdaten des Messdatensatzes erstellt sind.

Durch Anwenden wenigstens einer trainierten Ausgleichsfunktion 33 auf die Eingangsdaten ED können eine Ausgleichsinformation 38, welche in dem Messdatensatz fehlende Messdaten ausgleicht, umfassende Ausgangsdaten AD ermittelt und bereitgestellt werden.

Die Eingangsdaten können aus dem geladenen Messdatensatz erstellte Bilddaten, Messdaten (im k-Raum) oder Hybridraumdaten sein, und auch Navigatordaten ND umfassen.

Bei der Erstellung der Eingangsdaten aus dem geladenen Messdatensatz können z.B. Messdaten von k-Raumlinien des Messdatensatzes oder Messdaten von Segmenten des Messdatensatzes oder alle Messdaten des Messdatensatzes zur Erstellung von unterschiedlichen Eingangsdaten verwendet werden.

Die Ausgangsdaten können ebenso Bilddaten, k-Raumdaten oder Hybridraumdaten sein. Die Ausgangsdaten können hierbei aus Messdaten des Messdatensatzes erzeugten Eingangsdaten entsprechende aus den in dem Messdatensatz fehlenden Messdaten erzeugte Daten sein. Es ist jedoch auch denkbar, dass die Ausgangsdaten aus Messdaten des Messdatensatzes erzeugten Eingangsdaten entsprechende aus einem vollständigen Messdatensatz erzeugte Daten sind.

Bei einer Verwendung einer ein U-förmiges Netz 100 umfassenden Ausgleichsfunktion 33 werden z.B. den Eingangsdaten entsprechende Ausgangsdaten bereitgestellt, wodurch Eingangsdaten und Ausgangsdaten leicht verglichen werden können.

Im Folgenden werden einige Beispiele möglicher Ausgestaltungen des beschriebenen Verfahrens zum Erstellen von Ausgleichsdaten, welche in einem mittels einer PF-Technik aufgenommenen Messdatensatz fehlende Messdaten ausgleichen, beschrieben.

In einer einfachen Ausgestaltung kann die trainierte Ausgleichsfunktion 33 die Messdaten des geladenen Messdatensatzes MDS erhalten und als Ausgangsdaten die in dem geladenen Messdatensatz fehlenden Messdaten (im Beispiel der Figur 2 die Messdaten des Bereichs B1) oder einen vollständigen Messdatensatz (im Beispiel der Figur 2 Messdaten aller Segmente S1 bis S5) bereitstellen. Auf diese Weise liegen aus den Eingangsdaten und den Ausgangsdaten insgesamt Messdaten für einen vollständigen Messdatensatz vor, aus welchem, ggf. nach einer Konsistenzprüfung, ein Bilddatensatz mit erhöhter Bildschärfe rekonstruiert werden kann. Wird ein vollständiger Messdatensatz als Ausgangsdaten bereitgestellt, kann eine Konsistenzprüfung z.B. einen Vergleich und/oder ein Mitteln von in den Eingangsdaten umfassten Messdaten und diesen entsprechenden Messdaten der Ausgangsdaten umfassen. Wird bei der Konsistenzprüfung eine unerlaubte Abweichung der Messdaten der Eingangsdaten und der entsprechenden Messdaten der Ausgangsdaten festgestellt, kann erneut ein Ausgleichsverfahren, ggf. mit geänderten Eingangsdaten, initiiert werden.

Es ist auch denkbar, dass Ausgangsdaten auch auf Konsistenz geprüft werden, indem sie (falls sie nicht bereits so vorliegen) in den k-Raum transformiert werden und nur k-Raumdaten der Ausgangsdaten, die im geladenen Messdatensatz fehlenden Messdaten entsprechen, mit dem geladenen Messdatensatz zusammengeführt werden, um aus dem so zu einem vollständigen Messdatensatz zusammengeführten Satz an Messdaten und k-Raumdaten der Ausgangsdaten einen Bilddatensatz BDS zu rekonstruieren. Auf diese Weise werden die gemessenen Messdaten des geladenen Messdatensatzes unverändert übernommen.

In einer ersten konkreten Ausgestaltung der vorliegenden Erfindung kann vorgesehen sein, dass wenigstens eine trainierte Ausgleichsfunktion verwendet wird, die einen aus dem geladenen mittels PF-Technik aufgenommenen Messdatensatz rekonstruierten Bilddatensatz, insbesondere einen Satz komplexer Bilddaten, als Eingangsdaten erhält, und einen entsprechenden (komplexen) Bilddatensatz als Ausgangsdaten bereitstellt, in dem die Bildschärfe gegenüber den Eingangsdaten erhöht ist, so als wäre der geladene Messdatensatz in PF-Richtung vollständig abgetastet worden. Die erhöhte Bildschärfe entspricht somit einer Bildschärfe wie sie bei Rekonstruktion von Bilddatensätzen aus in PF-Richtung vollständig abgetastet Messdatensätzen erreicht wird. Das Fehlen von Messdaten in dem geladenen Messdatensatz wurde somit ausgeglichen.

In einer zweiten konkreten Ausgestaltung der vorliegenden Erfindung kann vorgesehen sein, dass wenigstens eine trainierte Ausgleichsfunktion verwendet wird, die einen aus dem aufgenommenen Messdatensatz rekonstruierten (insbesondere komplexen) Bilddatensatz als Eingangsdaten erhält, und einen (insbesondere komplexen) Bilddatensatz als Ausgangsdaten bereitstellt, der einem Satz an Differenzbilddaten entspricht, welcher eine Differenz eines Bilddatensatzes in dem die Bildschärfe gegenüber den Eingangsdaten erhöht ist, so als wäre der geladene Messdatensatz in PF-Richtung vollständig abgetastet worden, und der Eingangsdaten ist. Auf diese Weise wird die trainierte Ausgleichsfunktion auf die Differenzen zwischen einem aus dem geladenen Messdatensatz rekonstruierten Bilddatensatz und einem Bilddatensatz mit erhöhter Bildschärfe wie sie bei Rekonstruktion von Bilddatensätzen aus in PF-Richtung vollständig abgetasteten Messdatensätzen erreicht wird, fokussiert trainiert, wodurch Bildartefakten besonders gut vermieden werden können. Weiterhin kann bei Betrachtung von Differenzdaten besonders leicht, z.B. durch ein Vergleichen von erwarteter k-Raumenergie und aus den Ausgangsdaten ermittelter k-Raumenergie, eine Konsistenzprüfung der Ausgangsdaten mit den Eingangsdaten als Plausibilitätsprüfung der Ausgangsdaten durchgeführt werden. Ein Bilddatensatz mit erhöhter Bildschärfe kann dann durch Kombination der Eingangsdaten mit den Ausgangsdaten erhalten werden. Somit können die Ausgangsdaten auch Differenzbilddaten sein, die einer Differenz von aus einem einem vollständig aufgenommenen Messdatensatz entsprechenden Messdatensatz rekonstruierten Bilddaten und aus dem geladenen, mittels PF-Technik aufgenommenen und daher unvollständigen, Messdatensatz rekonstruierten Bilddaten entsprechen.

In einer dritten Ausgestaltung der vorliegenden Erfindung kann vorgesehen sein, dass wenigstens eine trainierte Ausgleichsfunktion verwendet wird, die aus dem aufgenommenen Messdatensatz rekonstruierten Hybridraumdaten als Eingangsdaten erhält, und Hybridraumdaten als Ausgangsdaten bereitstellt, in dem die Bildschärfe in der Richtung der Raumkoordinate des Hybridraums, insbesondere in PF-Richtung, gegenüber den Eingangsdaten erhöht ist, so als wäre der geladene Messdatensatz in dieser Richtung vollständig abgetastet worden. Durch eine Verwendung von Hybridraumdaten als Eingangsdaten und Ausgangsdaten wird die trainierte Ausgleichsfunktion auf die Richtung der Raumkomponente, bevorzugt die durch die PF-Technik nicht-vollständig abgetastete Richtung, konzentriert. Da hochfrequente Informationen der gemessenen Messdaten bei Verwendung einer PF-Technik nur in PF-Richtung, z.B. der Ausleserichtung, fehlen, ist eine räumliche Lokalisation von Effekten dieses Fehlens in die andere Aufnahmerichtung, z.B. die Phasenkodierrichtung, nicht erforderlich. Dieses Vorgehen ist insbesondere bei Verwendung weiterer Beschleunigungstechniken, wie z.B. ppa-Techniken in die nicht-PF-Richtung im Anschluss an eine Partial-Fourier-Ergänzung, insbesondere mit einem erfindungsgemäßen Ausgleichsverfahren, von Vorteil, da eine ppa-Rekonstruktion von in dieser Richtung durch die weitere Beschleunigung unterabgetasteten Messdaten weiter möglich ist.

Hybridraumdaten als Eingangsdaten können so in der in dem Messdatensatz nicht vollständig aufgenommenen Richtung in den Bildraum transformierte Hybridraumdaten sein. Beispielsweise, wenn der geladenen Messdatensatz in Ausleserichtung kx und Phasenkodierrichtung ky aufgenommen ist, wobei kx auch der PF-Richtung entspricht, können die Hybridraumdaten Daten im x-ky-Hybridraum sein. Durch eine Verwendung von Hybridraumdaten als Eingangsdaten (und Ausgangsdaten) wird die trainierte Ausgleichsfunktion auf die Richtung der Raumkomponente, bevorzugt die durch die PF-Technik nicht-vollständig abgetastete Richtung, konzentriert. Die Bildschärfe in so bereitgestellten Ausgangsdaten kann dann in PF-Richtung gegenüber den Eingangsdaten erhöht werden, so als wäre der geladene Messdatensatz in PF-Richtung vollständig abgetastet worden.

Bilddatensätze mit erhöhter Bildschärfe können aus den Hybridraumdaten rekonstruiert werden, z.B. durch eine weitere Fouriertransformation in die Richtung der noch im k-Raum liegenden Komponente der Hybridraumdaten.

In einer vierten Ausgestaltung der vorliegenden Erfindung kann vorgesehen sein, dass wenigstens eine trainierte Ausgleichsfunktion verwendet wird, die aus verschiedenen Bereichen des geladenen Messdatensatzes erstellte Eingangsdaten erhält, wobei die Bereiche den k-Raum in PF-Richtung aufteilen und insbesondere k-Raumlinien oder Segmente sein können. Die trainierte Ausgleichsfunktion stellt Ausgangsdaten bereit, die Bereichen, insbesondere k-Raumzeilen oder Segmenten, zugeordnet sind, deren Messdaten in dem geladenen Messdatensatz MDS fehlen.

Beispielsweise kann vorgesehen sein, dass wenigstens eine trainierte Ausgleichsfunktion verwendet wird, die aus verschiedenen Bereichen eines aus einem aufgenommenen Messdatensatz rekonstruierte Bilddatensätze bzw. Sätze an Hybridraumdaten bzw. Messdaten (im k-Raum) als Eingangsdaten erhält, und Bilddatensätze bzw. Sätze von Hybridraumdaten bzw. Messdaten (im k-Raum) von in dem aufgenommenen Messdatensatz fehlenden Bereichen oder von den in dem aufgenommenen Messdatensatz aufgenommenen und nicht-aufgenommenen Messdaten als Ausgangsdaten bereitstellt. Der geladenen Messdatensatz kann hierbei insbesondere bereits segmentweise aufgenommen worden sein, wobei ein Segment der segmentweisen Aufnahme des Messdatensatzes mit einem zur Erzeugung von Eingangsdaten verwendeten Bereich übereinstimmen kann, aber nicht muss. Durch eine Verwendung von Bereichen, die auch nur eine k-Raumlinie umfassen können, des aufgenommenen Messdatensatzes bei der Erzeugung der Eingangsdaten können Fehler, die bei einer Kombination einzelner Bereiche eines aufgenommenen Messdatensatzes entstehen können, ohne weitere ansonsten anzuwendende Fittingverfahren vermieden werden.

Die Eingangsdaten können dabei beispielsweise in der Kanaldimension konkateniert werden, wobei verschiedene Kombinationen denkbar sind. Einerseits kann jeder einzelne Bereich konkateniert verwendet werden, sodass, am Beispiel von Bilddaten, Bilddaten der einzelnen Bereiche aufgenommener Messdaten des geladenen Messdatensatzes MDS als Eingangsdaten konkateniert werden und die Ausgangsdaten Bilddaten von Bereichen der fehlenden Messdaten sind. Andererseits können Messdaten aus einzelnen Bereichen des geladenen Messdatensatzes zur Erstellung von Eingangsdaten verwendet werden, und als Ausgangsdaten ein Kombinationsbild aus allen Bereichen bereitgestellt werden.

Bei segmentweiser Aufnahme von Messdatensätzen werden die Segmente oft mit einem kleinen Überlapp zueinander aufgenommen. Die Ränder der Segmente werden dann üblicherweise mit einem klassischen Fitting-Algorithmus in Übereinstimmung gebracht, um eine verbesserte Kombination der Messdaten der einzelnen Segmente zu ermöglichen. Es gibt jedoch Situationen, in denen dies fehlschlägt. Für diese Fälle kann es vorteilhaft sein, wenn die Kombination der Segmente mittels eines neuronalen Netzes wie dem hierin beschriebenen durchgeführt wird. Trainingsdaten hierzu können gewonnen werden, indem das Fitting der Segmente manuell oder semi-automatisch nachjustiert wird, und die Kombination der optimal nachjustierten Segmente als Trainingsausgangsdaten für das Training verwendet werden.

Eine zweckmäßige, allgemeine Weiterbildung der Erfindung kann vorsehen, dass die Eingangsdaten weiterhin, d.h. zusätzlich, Navigatordaten ND umfassen, welche dem geladenen Messdatensatz MDS zugeordnet sind. Dadurch können, z.B. in den Navigatordaten ND enthaltene Informationen über eine bei der Aufnahme des Messdatensatzes herrschende Phasenlage, z.B. eine Hintergrundphase, mit in der trainierten Ausgleichsfunktion verwertet werden. Dadurch kann eine Stabilisierung der Ausgangsdaten erreicht werden, z.B. auch wenn starke Phasenvariationen zwischen einzelnen aufgenommenen Segmenten des aufgenommenen Messdatensatzes bestehen.

Weiterhin kann die Netzarchitektur so gewählt werden, dass keine vollständigen Bilder sondern auch Teilsegmente des k-Raums in k_{y}―Richtung oder gar nur einzelne k-Raum-Linien als Eingabe- und Ausgabedaten dienen können. Dies bietet insbesondere bei der Generierung von Trainingsdaten Vorteile.

Trainingseingangsdaten und Trainingsausgangsdaten für ein Trainieren der Ausgleichsfunktion 33 können aus vollständig (gemäß Nyquist), z.B. mittels einem EPI-Verfahren oder einem RESOLVE-Verfahren, aufgenommenen Messdatensätzen erstellt werden. Es können gemittelte Trainingsdaten verwendet werden.

Dazu können für ein Erzeugen von Trainingseingangsdaten Messdaten des vollständig aufgenommenen Messdatensatzes gemäß einer PF-Technik entfernt werden, und ein so erhaltener reduzierter Messdatensatz oder Bereiche dieses so reduzierten Messdatensatzes entweder direkt als Trainingseingangsdaten oder zur Erzeugung von Trainingseingangsdaten verwendet werden, z.B. durch Rekonstruktion von Bilddaten oder durch Überführung in einen Hybridraum. Weitere Trainingseingangsdaten können durch ein Spiegeln oder eine komplexe Konjugation von genannten reduzierten Messdatensätzen gewonnen werden.

Trainingsausgangsdaten können aus den vollständig aufgenommenen Messdatensätzen erzeugt werden, z.B. indem die in dem reduzierten Messdatensatz, der Basis für ein Erzeugen von Trainingseingangsdaten war, fehlenden Messdaten, oder fehlende Messdaten von Bereichen des k-Raums als Trainingsausgangsdaten verwendet werden, oder aus diesen fehlenden Messdaten Bilddaten rekonstruiert oder Hybridraumdaten als Trainingsausgangsdaten erzeugt werden. Differenzbilddaten als Trainingsausgangsdaten können durch Rekonstruieren von Bilddaten aus dem vollständig aufgenommenen Messdatensatz und Bilden der Differenz dieser Bilddaten mit aus dem reduzierten Messdatensatz rekonstruierten Bilddaten erzeugt werden.

Zusammenfassend, beschreibt das obige Verfahren eine Möglichkeit, in mittels PF-Technik aufgenommenen Messdatensätzen fehlende Messdaten auszugleichen, sodass eine Bildqualität von aus dem Messdatensatz rekonstruierten Bilddaten erhöht ist, ohne auf die Beschleunigung der Aufnahme durch die PF-Technik verzichten zu müssen, durch Verwendung eines entsprechend trainierten neuronalen Netzes.

Fig. 4 zeigt eine Prinzipskizze einer erfindungsgemäßen Ausgleichseinrichtung 39, die zur Durchführung des erfindungsgemäßen Ausgleichsverfahrens ausgebildet ist und beispielsweise als Teil einer Auswerteeinrichtung bzw. Steuereinrichtung einer Magnetresonanzanlage implementiert werden kann, und insbesondere als Teil einer Postprocessing-Pipeline dienen kann. Die Ausgleichseinrichtung 39 kann auch in sonstige Recheneinrichtungen integriert sein bzw. durch diese gebildet werden.

Zur Realisierung von Funktionseinheiten weist die Zuordnungseinrichtung 39 wenigstens einen Prozessor und wenigstens ein Speichermittel 40 auf. Über eine erste Schnittstelle 41 können Eingangsdaten entgegengenommen werden. In einer Ausgleichseinheit 42 wird die trainierte Ausgleichsfunktion angewendet, wobei die entstehenden Ausgangsdaten an einer zweiten Schnittstelle 43 bereitgestellt werden können. Die Ausgleichseinheit 42 kann als Untereinheiten beispielsweise auch eine Eingangsdatenzusammenstellungseinheit aufweisen, in der Eingangsdaten z.B. unterschiedlichen Kanälen zugeordnet werden können, um einen gemeinsamen Eingangsdatensatz aus verschiedenen Eingangsdaten zu bilden.

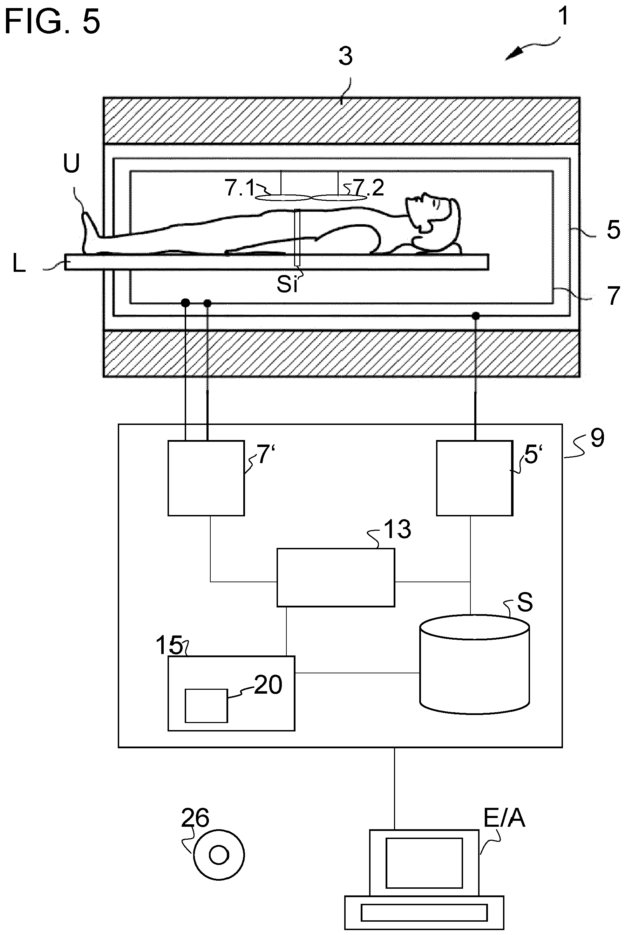

Figur 5 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9.

In der Figur 5 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schicht oder der Slab Si stellt ein exemplarisches Zielvolumen des Untersuchungsobjekts dar, aus dem Echosignale aufgenommen und als Messdaten erfasst werden sollen.

Die Steuereinrichtung 9 dient der Steuerung der Magnetresonanzanlage 1 und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei wird die Mittenfrequenz des, auch als B1―Feld bezeichneten, Hochfrequenz-Wechselfeldes in aller Regel möglichst so eingestellt, dass sie nahe der Resonanzfrequenz der zu manipulierenden Spins liegt. Abweichungen von der Mittenfrequenz von der Resonanzfrequenz werden als Off-Resonanz bezeichnet. Zur Erzeugung des B1―Feldes werden in der Hochfrequenzeinheit 7 mittels der Hochfrequenz-Sende-/Empfangs-Steuerung 7' gesteuerte Ströme an den HF-Spulen angelegt.

Weiterhin umfasst die Steuereinrichtung 9 eine Ausgleichseinrichtung 15, welche ein Modul 20 für ein maschinelles Lernen umfasst, und mit welcher erfindungsgemäße Verfahren durchgeführt werden können. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

## Patentansprüche

1. Computerimplementiertes Verfahren zum Erstellen von Ausgleichsdaten, welche in einem mittels einer partiellen Fourier-Technik (PF-Technik) aufgenommenen Messdatensatz fehlende (nicht-aufgenommene) Messdaten ausgleichen, umfassend die Schritte:
- Empfang von auf Basis von Messdaten des Messdatensatzes erstellten Eingangsdaten,
- Anwendung wenigstens einer trainierten Ausgleichsfunktion (33) auf die Eingangsdaten, wobei eine Ausgleichsinformation (38), welche in dem Messdatensatz fehlende Messdaten ausgleicht, umfassende Ausgangsdaten ermittelt werden,
- Bereitstellen der Ausgangsdaten.

2. Verfahren nach Anspruch 1, wobei eine ein faltendes U-förmiges neuronales Netz, z.B. ein U-Net, oder eine ein Up-Down-Netz umfassende Ausgleichsfunktion verwendet wird.

3. Verfahren nach einem der vorhergehenden Ansprüche, wobei die Eingangsdaten Bilddaten, Messdaten (im k-Raum) oder Hybridraumdaten sind.

4. Verfahren nach Anspruch 3, wobei die Eingangsdaten weiterhin Navigatordaten umfassen.

5. Verfahren nach einem der vorhergehenden Ansprüche, wobei Hybridraumdaten als Eingangsdaten in der in dem Messdatensatz nicht vollständig aufgenommenen Richtung in den Bildraum transformierte Hybridraumdaten sind.

6. Verfahren nach einem der vorhergehenden Ansprüche, wobei die Eingangsdaten aus Messdaten von k-Raumlinien des Messdatensatzes oder aus Messdaten von Segmenten des Messdatensatzes oder aus allen Messdaten des Messdatensatzes erstellt werden.

7. Verfahren nach einem der vorhergehenden Ansprüche, wobei die Ausgangsdaten (entsprechend der Eingangsdaten) Bilddaten, k-Raumdaten oder Hybridraumdaten sind.

8. Verfahren nach einem der vorhergehenden Ansprüche, wobei die Ausgangsdaten Differenzbilddaten sind, die einer Differenz von einem aus einem vollständig aufgenommenen Messdatensatz entsprechenden Messdatensatz rekonstruierten Bilddaten und aus dem geladenen Messdatensatz rekonstruierten Bilddaten entsprechen.

9. Verfahren nach einem der vorhergehenden Ansprüche, wobei die Ausgangsdaten aus Messdaten des Messdatensatzes erzeugten Eingangsdaten entsprechende aus den in dem Messdatensatz fehlenden Messdaten erzeugte Daten sind.

10. Verfahren nach einem der Ansprüche 1 bis 8, wobei die Ausgangsdaten aus Messdaten des Messdatensatzes erzeugten Eingangsdaten entsprechende aus einem vollständigen Messdatensatz erzeugte Daten sind.

11. Verfahren zum Vermeiden von Artefakten in aus einem mittels einer partiellen Fourier-Technik (PF-Technik) aufgenommenen Messdatensatz rekonstruierten Bilddaten umfassend die Schritte:
- Laden eines mittels einer PF-Technik aufgenommenen Messdatensatzes,
- Laden von Ausgangsdaten, die gemäß einem Verfahren nach einem der Ansprüche 1 bis 10 aus auf Basis von Messdaten des geladenen Messdatensatzes als Eingangsdaten bereitgestellte Ausgangsdaten sind,
- Erstellen eines Bilddatensatzes auf Basis von Messdaten des geladenen Messdatensatzes und den geladenen Ausgangsdaten.

12. Ausgleichseinrichtung zum Erstellen von Ausgleichsdaten, welche in einem mittels einer partiellen Fourier-Technik (PF-Technik) aufgenommenen Messdatensatz fehlende (nicht-aufgenommene) Messdaten ausgleichen, aufweisend
- eine erste Schnittstelle (41) zum Empfang von auf Basis von Messdaten des Messdatensatzes erstellten Eingangsdaten,
- eine Ausgleichseinheit (42) zur Anwendung wenigstens einer trainierten Ausgleichsfunktion (33) auf die Eingangsdaten, wobei eine Ausgleichsinformation (38) umfassende Ausgangsdaten ermittelt werden, und
- eine zweite Schnittstelle (43) zum Bereitstellen der Ausgangsdaten, wobei die Ausgleichseinrichtung derart ausgestaltet ist, dass sie ein Verfahren nach einem der Ansprüche 1 bis 11 durchführt.

13. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und mit einer Ausgleichseinrichtung (15) gemäß Anspruch 12, wobei die Steuereinrichtung (9) dazu ausgebildet ist, ein Verfahren nach einem der Ansprüche 1 bis 11 auf der Magnetresonanzanlage (1) auszuführen.

14. Computerprogramm, welches die Schritte eines Verfahrens nach einem der Ansprüche 1 bis 11 durchführt, wenn es auf einer Recheneinrichtung, insbesondere in einer Ausgleichseinheit (42) einer Ausgleichseinrichtung (39), ausgeführt wird.

15. Elektronisch lesbarer Datenträger, auf dem ein Computerprogramm nach Anspruch 14 gespeichert ist.
